# EUROPEAN PATENT APPLICATION

(11) **EP 1 968 114 A1**
(43) Date of publication of application: **10.09.2008**
(21) Application number: 08003982.9
(22) Date of filing: 04.03.2008
(51) Int. Cl.: H01L 23/498, H01L 23/58

(54) **Semiconductor device**

(30) Priority: 06.03.2007 JP 2007056216
(71) Applicant: Olympus Corporation, Tokyo 151-0072 (JP)
(72) Inventor: Kojima, Kazuaki, Tokyo, 151-0072 (JP); Igarashi, Takatoshi, Tokyo, 151-0072 (JP); Shiotani, Koichi, Tokyo, 151-0072 (JP); Matsumoto, Kazuya, Tokyo, 151-0072 (JP)
(74) Representative: Winter, Brandl, Fürniss, Hübner Röss, Kaiser, Polte Partnerschaft Patent- und Rechtsanwaltskanzlei

(57) **Abstract**

In a semiconductor device of the present invention, an electrode pad 103 is formed on a surface of a semiconductor substrate 101, and in the electrode pad 103, two different areas: a connection area of through wiring 103b electrically connected to a through wiring 110; and a pad area for inspection 103a that keeps away from an opening 111 b on the surface of a through hole 111, are set. Accordingly, the electrode pad 103 can be adequately prevented from being damaged due to contact of a probe, providing a high yield and reliability of the semiconductor device 100.
That is, because the through hole 111 is not opened directly below the pad area for inspection 103a with which the probe is in contact upon operation inspection of devices, a mechanical strength of the electrode pad 103 against the probe can be maintained in a high level.

## Description

### BACKGROUND OF THE INVENTION

### 1. Field of the Invention

The present invention relates to a semiconductor device having substrate through wiring, such as a semiconductor device of a chip-size package (CSP) type.

### 2. Description of the Related Art

In recent years, semiconductor devices have been increasingly required to be smaller and thinner. Then, in semiconductor devices of a chip-size package (CSP) type and a stacked multichip package (MCP) type, a technique has been used for electrically connecting electrode pads formed on a surface (on which devices and the like are formed) of a semiconductor substrate to a back side via substrate through wiring. For example, in the semiconductor device of a CSP type, an input/output terminal of a signal or the like is formed on a back side of a semiconductor substrate, and the input/output terminal is electrically connected to an electrode pad formed on the surface of the semiconductor substrate via a through wiring, thereby, upon implementation of the semiconductor device, a space needed for wire bonding and the like is reduced.

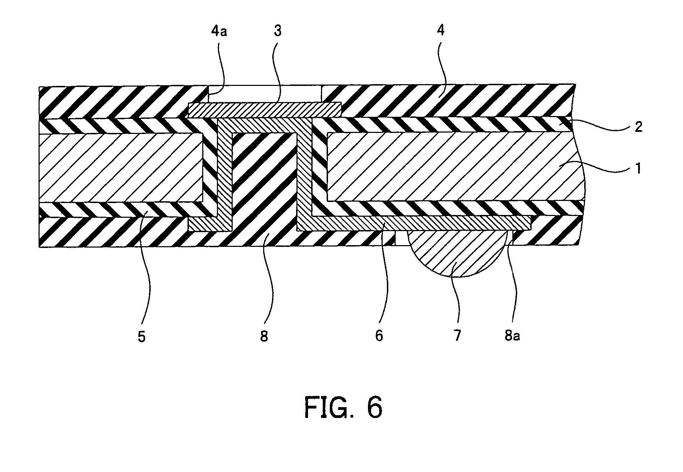

Specifically, for example, Patent Document 1 (Japanese Patent Laid-Open No. 2006-100435) discloses that, in a semiconductor device having an electrode pad 3 formed on the surface of a semiconductor substrate 1 through an insulating film 2, a through hole opened from a back side is formed directly below the electrode pad 3, and an insulating film 5 is formed to cover an inner wall of the through hole and the back side of the semiconductor substrate, and on the insulating film 5, a conductive film electrically connected to the electrode pad 3 is formed, thereby a through wiring 6 is formed (see Fig. 6). Here, on each upper layer of the electrode pad 3 and the through wiring 6, protective films 4 and 8 are formed, respectively. Then, in the back side of the semiconductor substrate 1, an opening 8a is opened in the protective film 8, and via the opening 8a, the through wiring 6 is electrically connected to an external input/output terminal 7. Accordingly, the surface side and the back side of the semiconductor substrate are conductively connected to each other, and upon implementation of the semiconductor device, external connection by wire bonding and the like is not required, thereby a package size can be made smaller. On the one hand, in the protective film 4 formed on the surface of the semiconductor substrate 1, an opening 4a is opened at a position corresponding to the through hole, and via the opening 4a, a part of the electrode pad 3 is exposed to the outside, thereby an inspection area used for probe inspection and the like is formed.

By the way, in the semiconductor device of such a type, to check operation of devices and the like after the substrate through wiring is formed, a probe, generally, is made in contact with the electrode pad to inspect. However, according to the technique disclosed in Patent Document 1 described above, because it is difficult to secure a sufficient, mechanical strength of the electrode pad, contact with the probe may damage the electrode pad, or in the worst case, the electrode pad may be broken. Further, also in a part with which the probe is not in contact, there is a problem that a mechanical strength is poor because the through hole is formed directly below.

The present invention is made in view of the mentioned above, and an object thereof is to provide a semiconductor device in which, even if a through wiring is provided, an electrode pad can be adequately prevented from being damaged due to contact with a probe and the like, and which can achieve a high yield and reliability.

### SUMMARY OF THE INVENTION

A semiconductor device according to the present invention includes: a device formed on a surface of a substrate; an electrode pad formed on the surface of the substrate and electrically connected to the device; and a through hole passing through the substrate below the electrode pad; and a through wiring formed in the through hole and electrically connected to the electrode pad, wherein the electrode pad includes: a connection area of through wiring electrically connected to the through wiring; and a pad area for inspection set at a position which keeps away from an opening on the surface of the through hole.

The above and other objects, features and advantages of the invention will become more clearly understood from the following description referring to the accompanying drawings.

### BRIEF DESCRIPTION OF THE DRAWINGS

Fig. 1 is a plan view illustrating a general configuration of a semiconductor device according to a first embodiment of the present invention;
Fig. 2 is an enlarged view of an area II in Fig. 1;
Fig. 3 is a cross-sectional view taken along III-III in Fig. 2;
Fig. 4 is an enlarged plan view illustrating a main portion of a semiconductor device according to a second embodiment of the present invention;
Fig. 5 is a cross-sectional view taken along V-V in Fig. 4; and
Fig. 6 is a cross-sectional view illustrating a main portion of a semiconductor device according to a conventional art.

### DETAILED DESCRIPTION OF THE PREFERRED EMBODIMENTS

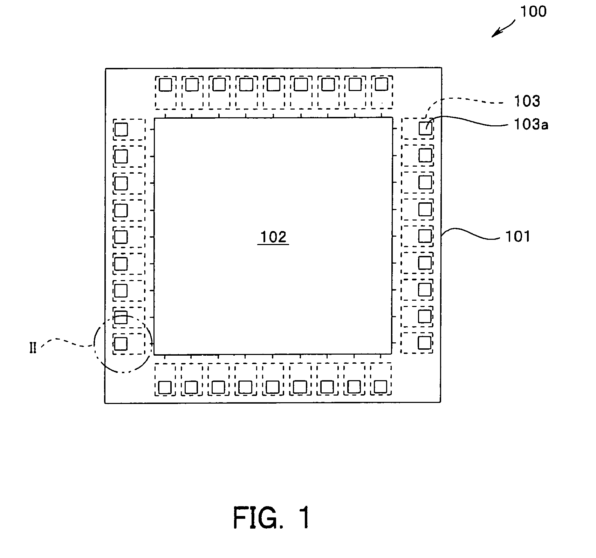

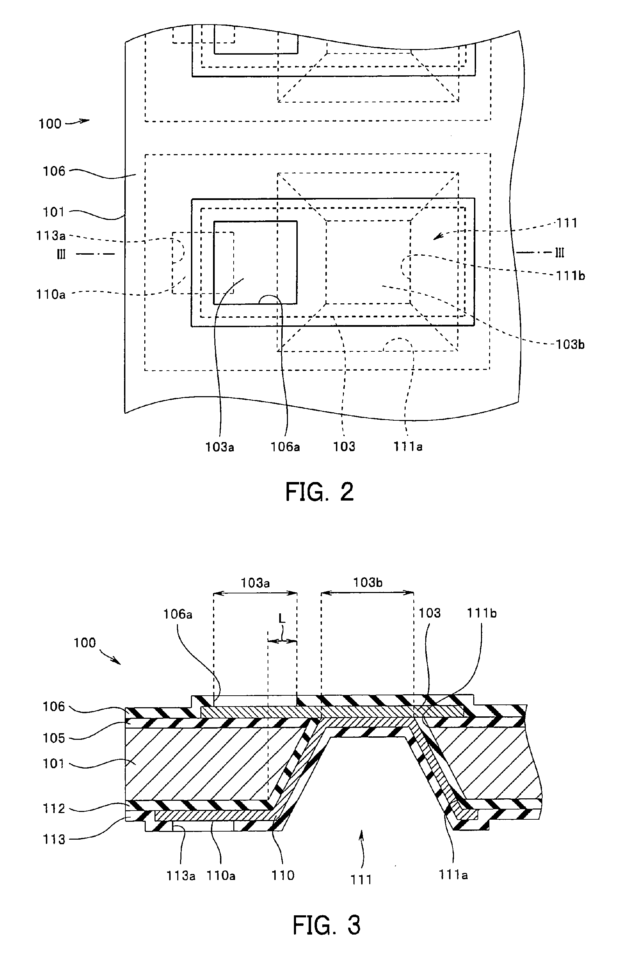

Now, embodiments of the present invention will be hereinafter described with reference to the accompanying drawings. Figs. 1 to 3 are views in relation to a first embodiment of the present invention. Fig. 1 is a plan view illustrating a general configuration of a semiconductor device. Fig. 2 is an enlarged view of an area II in Fig. 1. Fig. 3 is a cross-sectional view taken along III-III in Fig. 2.

As shown in Fig. 1, a semiconductor device 100 of the present embodiment has a semiconductor substrate (substrate) 101 formed in an approximately rectangular shape in a top view, and on a surface of the semiconductor substrate 101, for example, a device area 102 is set where multiple, various devices (not shown) such as a semiconductor element and a micro-machine are provided at predetermined positions, respectively. Further, on the surface of the semiconductor substrate 101, a plurality of electrode pads 103 for input/output signals, electrically connected to the various devices in the device area 102 is formed along an edge side portion of the semiconductor substrate 101.

As shown in Figs. 2 and 3, each of the electrode pads 103, which, for example, is made of a conductive layer of aluminum, is formed on an upper layer of an insulating film 105 formed on the surface of the semiconductor substrate 101. Further, on an upper layer of the electrode pad 103, a protective film 106 made of an insulating film of a silicon oxide film or the like is formed, and in the protective film 106, an opening 106a is formed to expose a part of the electrode pad 103 to the outside. Then, an area on the electrode pad 103 exposed to the outside via the opening 106a is set to be a pad area for inspection 103a, and in production process of the semiconductor device 100 or the like, a probe etc. is made in electrical contact with the pad area for inspection 103a to allow for operation check or the like of the various devices in the device area 102.

Further, below the electrode pad 103, a through wiring 110 is formed that passes through the semiconductor substrate 101 to conductively connect the electrode pad 103 to the back side.

Specifically described, in the electrode pad 103, a connection area of through wiring 103b for being electrically connected to the through wiring 110 is set in an area different from the pad area for inspection 103a, and below the connection area of through wiring 103b, a through hole 111 is formed that passes through the semiconductor substrate 101 from the back side to the surface. Further, on the semiconductor substrate 101, an insulating film 112 is formed to cover an inner wall of the through hole 111 and the back side of the semiconductor substrate 101, and on an upper layer of the insulating film 112, the through wiring 110 is formed. In the through hole 111, a contact hole corresponding to the connection area of through wiring 103b is formed in the insulating film 112, and via the contact hole, the through wiring 110 is electrically connected to the electrode pad 103.

Further, on an upper layer of the through wiring 110, a protective film for the back side 113 made of a silicon oxide film or the like is formed. In the protective film for the back side 113, an opening 113a is formed to expose a part of the through wiring 110 to the outside, and an area exposed to the outside via the opening 113a is set to be an electrode pad on the back side 110a. Then, the electrode pad on the back side 110a allows the semiconductor device 100 to be directly implemented on various devices without use of wire bonding or the like. In addition, the electrode pad on the back side 110a can be set at an arbitrary position on the back side of the semiconductor substrate 101 in an area where the through hole 111 is not formed.

Here, to suppress generation of cleavage of the semiconductor substrate 101 beginning at the through hole 111 or the like, the through hole 111, wherever possible, is preferably formed at a position spaced apart from an end face of the semiconductor substrate 101. Then, in the present embodiment, the connection area of through wiring 103b (the through hole 111) on the electrode pad 103 is set to be positioned more inward relative to the pad area for inspection 103a in the surface of the semiconductor substrate 101.

Further, as shown in Figs. 2 and 3, in the present embodiment, the through hole 111 is configured to be a tapered through hole in which an opening area of the opening 111a on the back side is formed relatively larger than that of the opening 111b on the surface. Then, forming the through hole 111 in the tapered shape allows the opening area of the opening 111a on the back side of the through hole 111 to be sufficiently secured, thereby the through wiring 110 can be suitably formed. In addition, the pad area for inspection 103a is set at a position which keeps away from the opening 111 b on the surface of the through hole 111, and where at least a part of the pad area for inspection 103a overlaps with the opening 111a on the back side, thereby a space for setting the pad area for inspection 103a needed on the semiconductor substrate 101 can be efficiently reduced. In addition, the tapered through hole 111 described above, for example, in the case where a silicon substrate is used for the semiconductor substrate 101, can be easily formed by a method such as anisotropic etching (for example, wet etching) whose etching rate in a direction [100] of the silicon substrate is relatively higher than that in a direction [111].

According to such embodiment, two different areas: the connection area of through wiring 103b electrically connected to the through wiring 110; and the pad area for inspection 103a which keeps away from the opening 111 b on the surface of the through hole 111, are set in the electrode pad 103 formed on the surface of the semiconductor substrate 101, thereby the electrode pad 103 can be adequately prevented from being damaged due to contact with a probe or the like, providing a high yield and reliability of the semiconductor device 100. That is, because the through hole 111 is not opened directly below the pad area for inspection 103a with which a probe is in contact upon operation inspection of devices and the like, a mechanical strength of the electrode pad 103 against the probe etc. can be maintained in a high level.

At this time, the through hole 111 is formed more inward relative to the pad area for inspection 103a in the surface of the semiconductor substrate 101, thereby damage (chip crack) or the like of the semiconductor substrate upon dicing etc. can be prevented, and further improvement of yield can be achieved.

Further, to augment the strength of the electrode pad 103 itself, a new, special process is not necessary, and while a production cost is kept, the strength of the electrode pad 103 can be improved.

In addition, the present embodiment has been described with reference to one example using the tapered through hole 111, but not limited thereto, the through hole may be obviously a through hole having an arbitrary shape.

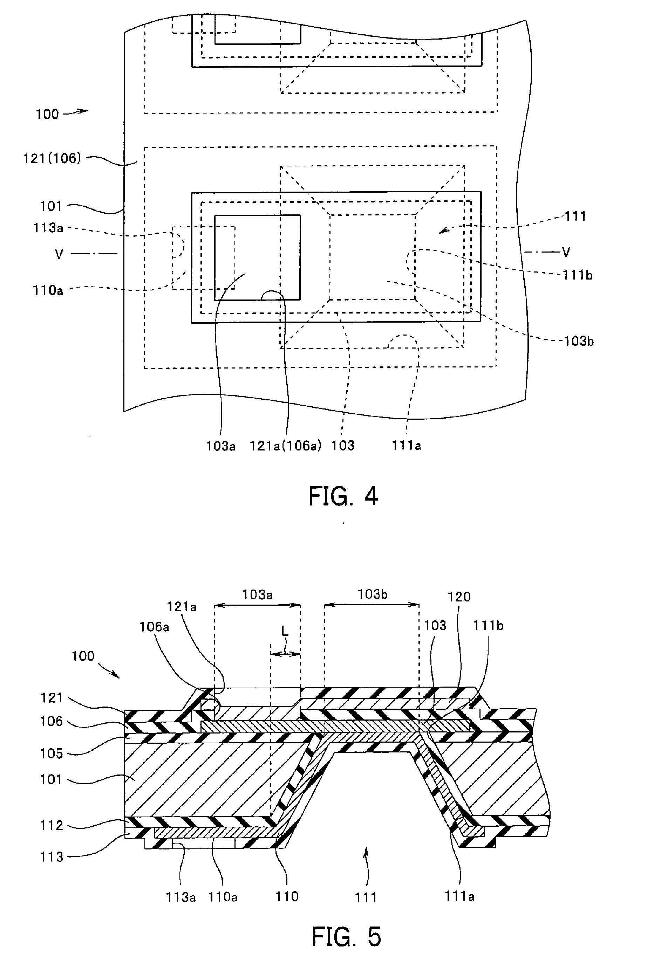

Next, Figs. 4 and 5 are views in relation to a second embodiment of the present invention. Fig. 4 is an enlarged plan view illustrating a main portion of a semiconductor device. Fig. 5 is a cross-sectional view taken along V-V in Fig. 4. In addition, in the present embodiment, a similar component as that of the first embodiment described above is indicated by the similar symbol, and the description is omitted.

As shown in Figs. 4 and 5, in the present embodiment, a conductive film 120 made of aluminum or the like is laminated on an upper layer of an electrode pad 103 via a protective film 106, and further on an upper layer of the conductive film 120, an insulating film 121 is laminated. In addition, similarly to the protective film 106, the insulating film 121 has an opening 121 a corresponding to a pad area for inspection 103a provided therein. Here, the conductive film 120 and the insulating film 121 are desirably formed at the same time of forming a film which is formed upon formation of various devices in a device area 102.

According to such embodiment, in addition to the similar advantage as the first embodiment described above, the strength of the electrode pad 103 itself can be augmented due to a laminated structure formed on the upper layer thereof, thereby damage or the like of the electrode pad 103 can be more effectively reduced, and further improvement of yield and/or reliability can be achieved.

In addition, the present embodiment has been described referring to one example in which the bilaminar film is laminated on the upper layer of the protective film 106 to improve the strength of the electrode pad 103, but a film having three or more layers may be obviously laminated. Also, the conductive film and the insulating film to be laminated on the upper layer of the protective film 106 may be made of material of a similar type as that of the electrode pad 103 and the protective film 106, respectively, or may be made of different material.

Also, in view of augmenting a lowered strength of the electrode pad 103 due to opening of the through hole 111, the film may be laminated on the upper layer of the protective film 106 at least in an area corresponding to a connection area of through wiring 103b.

Further, instead of formation of the multilayer film on the upper layer of the protective film 106, for example, it is also possible to thicken film thicknesses of the electrode pad 103 and the protective film 106. At this time, a preferable thickness is, for example, equal to or more than 1 µm for the electrode pad 103, and equal to or more than 2 µm for the protective film 106.

Having described the embodiments of the invention referring to the accompanying drawings, it should be understood that the present invention is not limited to those precise embodiments and various changes and modifications thereof could be made by one skilled in the art without departing from the spirit or scope of the invention as defined in the appended claims.

## Claims

1. A semiconductor device, comprising:
a device formed on a surface of a substrate;
an electrode pad formed on the surface of the substrate and electrically connected to the device;
a through hole passing through the substrate below the electrode pad; and
a through wiring formed in the through hole and electrically connected to the electrode pad, wherein
the electrode pad includes: a connection area of through wiring electrically connected to the through wiring; and a pad area for inspection set at a position which keeps away from an opening of the through hole on a surface side.

2. The semiconductor device according to claim 1, wherein
the connection area of through wiring of the electrode pad is formed more inward relative to the pad area for inspection in the surface of the substrate.

3. The semiconductor device according to claim 1 or 2, wherein
a multilayer structure where a plurality of films is laminated is formed at least in the connection area of through wiring of the electrode pad.

4. The semiconductor device according to any one of claims 1 to 3, wherein
the through hole is a tapered through hole in which an opening area of an opening on a back side is formed relatively larger than that of an opening on the surface, and
the pad area for inspection is formed at a position where at least a part of the pad area for inspection overlaps with the opening on the back side of the through hole.
